Europäisches Patentamt

European Patent Office

Office européen des brevets

(11) Veröffentlichungsnummer: **0 222 400 B1**

# EUROPÄISCHE PATENTSCHRIFT

(45) Veröffentlichungstag der Patentschrift: **22.01.92**

(51) Int. Cl.⁵: **H01L 21/312**, H01L 21/306

(21) Anmeldenummer: **86115750.1**

(22) Anmeldetag: **13.11.86**

(54) **Verfahren zum Schutz von polierten Siliciumoberflächen.**

(30) Priorität: **14.11.85 DE 3540469**

(43) Veröffentlichungstag der Anmeldung:
**20.05.87 Patentblatt 87/21**

(45) Bekanntmachung des Hinweises auf die Patenterteilung:
**22.01.92 Patentblatt 92/04**

(84) Benannte Vertragsstaaten:
**DE FR GB IT NL**

(56) Entgegenhaltungen:
**DE-A- 1 915 085**

**JOURNAL OF THE ELECTROCHEMICAL SO-CIETY, Band 116, Nr. 3, März 1969, Seiten 377-380; M. CONTI et al.: "Electrical properties of silicone films on silicon"**

**IBM TECHNICAL DISCLOSURE BULLETIN, Band 28, Nr. 5, Oktober 1985, Seite 1907, New York, US; "High silicon content, all dry process packaging material"**

**IBM TECHNICAL DISCLOSURE BULLETIN, Band 20, Nr. 5, Oktober 1977, Seiten 1746-1747, New York, US; K.D. BEYER: "Silicon surface cleaning process"**

**JOURNAL OF THE ELECTROCHEMICAL SO-CIETY, Band 132, Nr. 8, August 1985, Seiten 1925-1932, Manchester, New Hampshire, US; V.S. NGUYEN et al.: "Plasma organosilicon polymers. Deposition, characterization, and application in multilayer resist"**

(73) Patentinhaber: **Wacker-Chemitronic Gesellschaft für Elektronik-Grundstoffe mbH Johannes-Hess-Strasse 24 W-8263 Burghausen(DE)**

(72) Erfinder: **Lampert, Ingolf Kettelerstrasse 21 W-8263 Burghausen(DE)**

EP 0 222 400 B1

**Beschreibung**

Die Erfindung betrifft ein Verfahren zum Schutz von polierten Siliciumoberflächen.

Bei Siliciumscheiben ist die während des Poliervorganges, welcher z.B. gemäß der US-PS 4 270 316 durchgeführt werden kann, hergestellte einwandfreie Oberfläche bereits unmittelbar nach dessen Beendigung einer Fülle von Einwirkungen, z.B. durch Waschlösungen, Wasser, oder die umgebende Atmosphäre ausgesetzt, die die Oberflächenqualität beeinflussen können.

Eine bekannte Möglichkeit zur Weiterbehandlung der Oberfläche besteht darin, die Siliciumscheiben nach dem Poliervorgang einer oxidierenden Reinigung zu unterwerfen. Bei dieser Behandlung, die im allgemeinen in bekannter Weise (vgl. z.B. W. Kern, D. Puotinen, RCA Review, June 1970, S. 187-206), z.B. durch Eintauchen in eine Wasserstoffperoxid/Ammoniak-Lösung durchgeführt wird, überzieht sich die polierte Oberfläche mit einer dünnen Schicht aus teilweise hydratisiertem Siliciumdioxid. Diese Schicht verhindert in der Regel auch während längerer Lagerung der Scheiben eine Kontamination der Oberfläche durch in der umgebenden Amtosphäre gegenwärtige Kohlenstoffverbindungen, z.B. Kohlenwasserstoffe. Allerdings ändert sich, vor allem während längerer Lagerzeiten, aufgrund von Alterungseffekten auch die Struktur der Schutzschicht. Solche Änderungen können nach einem nachgeschalteten thermischen Oxidationsschritt(beispielsweise bei 1000 °C in trockenem Sauerstoff) die als "haze" bezeichneten schleierartigen Eintrübungen auf der polierten Oberfläche verursachen, die z.B. bei Überprüfung der Scheibenoberfläche im gebündelten Licht als diffuse Oberflächenreflexionen sichtbar werden.

Aufgabe der Erfindung war es daher, ein Verfahren anzugeben, das einen zuverlässigen, langanhaltenden, reproduzierbaren Schutz von polierten, oxidierend gereinigten Siliciumoberflächen gewährleistet, insbesondere im Hinblick auf im Rahmen der Herstellung elektronischer Bauelemente erforderliche thermische Oxidationsschritte.

Gelöst wird die Aufgabe durch ein Verfahren, welches dadurch gekennzeichnet ist, daß unmittebar im Anschluß an oder innerhalb von höchstens 10 Stunden nach der in an sich bekannter Weise durchgeführte oxidierende Reinigung die Siliciumoberfläche der Einwirkung eines eine Trialkylsilylierung der Oberfläche bewirkenden Reagens unterworfen und dadurch mit einen Schutzschicht überzogen wird.

Für die Aufbringung der Oxidschicht eignet sich insbesondere das bereits erwähnte und zur Nachbehandlung von polierten Siliciumscheiben weithin übliche Verfahren, bei dem diese nach dem Polieren und Entfernung der Polierrückstände kurzzeitig in eine wäßrige ammoniakalische Wasserstoffperoxidlösung (vgl. z.B. W. Kern, D. Puotinen, a.a.O. oder W. Kern, Semiconductor International, April 1984, S. 94-99) eingetaucht werden. Grundsätzlich sind zwar auch andere Methoden der Oxidation nicht ausgeschlossen, z.B. mittels Natriumhypochloritlösung oder anodischer Oxidation in alkalischer Lösung; bei diesen Methoden besteht jedoch meist die Gefahr einer Kontamination der Scheibenoberfläche mit störenden Kationen.

Im Anschluß an die oxidierende Reinigung werden die polierten Siliciumscheiben vorteilhaft noch gewaschen und getrocknet und stehen dann für den nächsten Behandlungsschritt zur Verfügung, bei welchem die polierte Siliciumoberfläche der Einwirkung eines zur Trialkylsilylierung geeigneten Reagens unterworfen wird. Zweckmäßig wird diese Behandlung möglichst unmittelbar im Anschluß an die oxidierende Reinigung durchgeführt, obwohl erfahrungsgemäß Wartezeiten von bis zu etwa 10 Stunden noch toleriert werden können.

Geeignete Reagentien sind insbesondere Hexaalkyldisilazane, vorzugsweise Hexamethyldisilazan. Letztere Verbindung ist eine bei der Bauelementeherstellung häufig als Haftvermittler für Fotolacke verwendete Chemikalie. Ihre Verwendung läßt daher auch keine Komplikationen beim Einsatz der erfindungsgemäß behandelten polierten Siliciumscheiben bei der Herstellung elektronischer Bauelemente erwarten. Eine mögliche Erklärung für die Wirkung der geeigneten Verbindungen ist die, daß sie vermutlich mit den auf der oxidierten Siliciumoberfläche vorhandenen OH-Gruppen unter Trialkyl- bzw. Trimethylsilylierung reagieren, diese somit mit einem dünnen Schutzfilm überziehen und zugleich die Zentren beseitigen, an denen z.B. durch Wasserabspaltung zwischen verschiedenen Si-OH-Gruppen ein der Alterung von Kieselsäuren ähnlicher Prozeß ablaufen kann.

Grundsätzlich ist es auch möglich, das jeweils ausgewählte Reagens in flüssiger Form, sei es direkt oder mit einem Lösungsmittel, wie etwa Trifluortrichlorethan, verdünnt, auf die Scheibenoberfläche aufzubringen, beispielsweise aufzuschleudern. Das günstigere und im Rahmen der Erfindung schon aus Reinheitsgründen bevorzugte Verfahren besteht jedoch darin, das Reagens gasförmig zur Einwirkung auf das Silicium zu bringen. Dies kann beispielsweise in einer Reaktionskammer geschehen, in der eine das Reagens in der gewünschten Konzentration enthaltende Atmosphäre vorgelegt ist und in welche die Siliciumscheiben für die zur Absättigung der Oberfläche benötigte Zeit eingebracht werden können.

Zweckmäßig wird die Arbeitsatmosphäre mittels eines beispielsweise die Kammer durchströmenden Trägergases eingestellt, dem z.B. mit Hilfe eines temperaturkontrollierten Verdampfers (bubbler) die jeweils erforderliche Menge des Reagens zugefügt wird, wobei diese Zufuhr auch in einen vom Gesamtgasstrom abgezweigten Teilstrom erfolgen kann. Die benötigte Menge ist in der Regel gering; sie liegt beispielsweise bei dem bevorzugt eingesetzten Hexamethyldisilazan bei etwa 1 bis 15 mg/l Trägergas. Grundsätzlich mögliche höhere Anteile bis hin zur Sättigung des Trägergases sind meistenteils nicht erforderlich.

Als Trägergase kommen in erster Linie die in der Siliciumtechnologie gebräuchlichen Inertgase, z.B. Stickstoff, Argon oder Freone (z.B. $CF_2Cl_2$) in Frage. Beim grundsätzlich gleichfalls möglichen Einsatz von Luft oder anderen oxidierenden Gasen (z.B. $O_2$) ist jedoch die in den meisten Fällen erhebliche Oxidationsempfindlichkeit von zur Alkylsilylierung geeigneten Reagentien, wie Hexamethyldisilazan, zu berücksichtigen.

Die Einwirkungsdauer kann in der Regel kurz, d.h. im Bereich weniger Minuten, gehalten werden. Beispielsweise ist beim Einsatz des bevorzugten Hexamethyldisilazans zumeist nach eine Verweilzeit der Scheiben von etwa 0,2 bis 5 Minuten eine vollständige Absättigung der Oberfläche mit Trimethylsilylgruppen gewährleistet.

Die solcherart behandelten Scheiben besitzen nunmehr eine Schutzschicht, die auch bei mehrmonatiger Lagerung eine Alterung der durch die oxidierende Reinigung aufgebrachten Oxidschicht verhindert.

Die Trialkylsilylgruppen der Schutzschicht können bei der Bauelementeherstellung durch eine - ohnehin zu Beginn der meisten Prozesse durchgeführte - thermische Oxidation entfernt werden. Dabei verbrennen die Alkylgruppen zu gasförmigem Kohlendioxid und Wasser und können über die Gasphase entweichen. Die auf der Scheibenoberfläche verbleibende Schicht von mit Sauerstoff abgesättigtem Silicium ist von den gewöhnlich bei Oxidationsprozessen auf Siliciumoberflächen entstehenden Schichten nicht zu unterscheiden und ist damit für die nachfolgenden Bearbeitungsschritte unschädlich.

Das erfindungsgemäße Verfahren bietet damit die Möglichkeit, polierte Siliciumoberflächen nach einer oxidierenden Reinigung zuverlässig auch bei mehrmonatiger Lagerung vor Alterungseffekten zu bewahren. Ein besonderer Vorteil liegt darin, daß sich die erfindungsgemäß eingesetzten Reagentien, insbesondere Hexamethyldisilazan, mit geringem apparativem Aufwand und unter reinsten Bedingungen (Gasphase) aufbringen und ohne störende Rückstände wieder beseitigen lassen.

Ausführungsbeispiel

50 Siliciumscheiben (Durchmesser 10 cm, (100)-Orientierung) wurden in einer handelsüblichen Poliermaschine unter üblichen Bedingungen (alkalisches $SiO_2$-Sol, ca. 40 °C) einem Poliervorgang unterworfen. Anschließend wurden die Scheiben entnommen und durch Eintauchen in eine auf ca. 85 °C gehaltene Reinigungsmischung (1 Teil 30 Gew.-%-iges $H_2O_2$, 1 Teil konz. $NH_3$, 6 Teile Wasser) für etwa 15 Minuten einer oxidierenden Reinigung unterzogen. Danach wurden die Scheiben mit deionisiertem Wasser gespült und getrocknet.

Unmittelbar im Anschluß daran wurde nun eine Horde mit 25 Scheiben einer Behandlung mit Hexamethyldisilazan unterzogen. Zu diesem Zweck war eine Behandlungskammer vorgesehen, in welcher eine Argonatmosphäre mit einem Anteil von ca. 10 mg Hexamethyldisilazan/l Argon vorlag. Diese Arbeitsatmosphäre wurde in der Weise eingestellt, daß von einem Argonstrom (ca. 100 l/h) vor dem Eintreten in die Kammer ein Teilstrom abgezweigt wurde. Dieser wurde über einen mit Hexamethyldisilazan beschickten, auf 26 °C thermostatisierten Verdampfer (bubbler) geführt, nahm dort einen entsprechenden Anteil Hexamethyldisilazandampf auf und wurde schließlich wieder mit dem restlichen Argonstrom vereinigt, um dann durch die Behandlungskammer geleitet zu werden. Die Durchflußraten der Teilströme und die Verdampfertemperatur wurden so aufeinander abgestimmt, daß in der Kammer der gewünschte Anteil von 10 mg Hexamethyldisilazan/l Gas gewährleistet war. Die Horde mit den für die Behandlung vorgesehenen Scheiben wurde nun in die Behandlungskammer gestellt und nach einer Einwirkungszeit von etwa 1,5 Minuten wieder entnommen.

Die so behandelten 25 Scheiben wurden nun, ebenso wie die restlichen 25 unbehandelten Scheiben, für ca. 40 Tage in einem Scheibenaufbewahrungsbehälter stehengelassen, welcher zwar geschlossen, aber nicht hermetisch dicht war. Im Raum lagen dabei Reinraumbedingungen gemäß der Klasse 100 des US Federal Standard 209 a vor.

Anschließend wurden sämtliche Scheiben unter genau gleichen Bedingungen einer Oxidation (trockener Sauerstoff, ca. 1000 °C, ca. 100 Minuten Dauer) unterworfen, wobei eine Oxidschicht von ca. 70nm (700 Å) Dicke erzeugt wurde. Zur Kontrolle der Oberflächenqualität wurden dann die Scheiben im gebündelten Licht auf etwaige schleierartige Eintrübungen ("haze") untersucht.

Auf allen 25 unbehandelten Scheiben waren auf der Oberfläche die für den "haze" charakteristischen diffusen Oberflächenreflexionen zu beobachten.

Die 25 in der erfindungsgemäßen Weise behandelten Scheiben besaßen hingegen eine völlig einwandfreie Oberfläche, so daß keinerlei diffuse Oberflächenreflexionen festzustellen waren.

## Patentansprüche

1. Verfahren zum Schutz polierter Siliciumoberflächen, **dadurch gekennzeichnet,** daß unmittelbar im Anschluß an oder innerhalb von höchstens 10 Stunden nach einer in an sich bekannter Weise durchgeführten oxidierenden Reinigung die polierte Siliciumoberfläche der Einwirkung eines eine Trialkylsilylierung der Oberfläche bewirkenden Reagens unterworfen und dadurch mit einen Schutzschicht überzogen wird.

2. Verfahren nach Anspruch 1, **dadurch gekennzeichnet,** daß das Reagens aus der Gruppe der Hexaalkyldisilazane ausgewählt wird.

3. Verfahren nach einem der Ansprüche 1 oder 2, **dadurch gekennzeichnet,** daß als Reagens Hexamethyldisilazan eingesetzt wird.

4. Verfahren nach einem der Ansprüche 1 bis 3, **dadurch gekennzeichnet,** daß das Reagens in gasförmigem Zustand eingesetzt wird.

5. Verfahren nach einem der Ansprüche 1 bis 4, **dadurch gekennzeichnet,** daß das Reagens einem Trägergas in einer Konzentration von bis zu 15 mg Reagens/l Trägergas beigemischt wird.

6. Verfahren nach einem der Ansprüche 1 bis 5, **dadurch gekennzeichnet,** daß das Reagens für eine Dauer von 0,5 bis 5 Minuten zur Einwirkung gebracht wird.

7. Verfahren nach einem der Ansprüche 1 bis 6, **dadurch gekennzeichnet,** daß die durch die Einwirkung des Reagens auf der Siliciumoberfläche entstandene Schutzschicht durch einen thermischen Oxidationsschritt wieder entfernbar ist.

## Claims

1. Process for protecting polished silicon surfaces, characterised in that, directly following or within not more than 10 hours after an oxidative cleaning carried out in a manner known per se, the polished silicon surface is subjected to the action of a reagent effecting trialkylsilylation of the surface and is thereby coated with a protective layer.

2. Process according to Claim 1, characterised in that the reagent is selected from the group of the hexaalkyldisilazanes.

3. Process according to one of Claims 1 or [sic] 2, characterised in that hexamethyldisilazane is employed as the reagent.

4. Process according to one of Claims 1 to 3, characterised in that the reagent is employed in the gaseous state.

5. Process according to one of Claims 1 to 4, characterised in that the reagent is admixed to a carrier gas in a concentration of up to 15 mg of reagent/litre of carrier gas.

6. Process according to one of Claims 1 to 5, characterised in that the reagent is allowed to act for a period of 0.5 to 5 minutes.

7. Process according to one of Claims 1 to 6, characterised in that the protective layer produced on the silicon surface by the action of the reagent is removable again by a thermal oxidation step.

## Revendications

1. Procédé pour la protection de surfaces de silicium polies, procédé caractérisé en ce que, aussitôt après ou au maxium dans les 10 heures qui suivent un nettoyage oxydant effectué de manière connue, on soumet les surfaces polies à l'action d'un réactif y produisant une trialkylsilylation, ce qui recouvre la surface d'une couche protectrice.

2. Procédé selon la revendication 1 caractérisé en ce que le réactif est pris dans la catégorie des hexaalkyldisilazanes.

3. Procédé selon la revendication 1 ou 2 caractérise en ce que le réactif est l'hexaméthyldisilazane.

4. Procédé selon l'une des revendications 1 à 3, caractérisé en ce que le réactif est appliqué à l'état gazeux.

5. Procédé selon l'une des revendications 1 à 4, caractérisé en ce que le réactif est mélangé à un gaz véhicule à une teneur pouvant s'élever jusqu'à 15 mg/l du gaz véhicule.

6. Procédé selon l'une des revendications 1 à 5 caractérisé en ce qu'on laisse agir le réactif pendant une durée de 0,5 à 5 minutes.

7. Procédé selon l'une des revendications 1 à 6, caractérisé en ce que la couche protectrice formée par le réactif à la surface du silicium peut ensuite être enlevée par une oxydation à chaud.